(19) Europäisches Patentamt
European Patent Office
Office européen des brevets

(11) EP 2 947 663 A1

(12) **EUROPEAN PATENT APPLICATION**
published in accordance with Art. 153(4) EPC

(43) Date of publication:
**25.11.2015 Bulletin 2015/48**

(21) Application number: **14740438.8**

(22) Date of filing: **14.01.2014**

(51) Int Cl.:
***H01B 5/00*** *(2006.01)*

(86) International application number:
**PCT/JP2014/050456**

(87) International publication number:
**WO 2014/112475 (24.07.2014 Gazette 2014/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.01.2013 JP 2013008427**

(71) Applicant: **Toray Industries, Inc.**
**Tokyo 103-8666 (JP)**

(72) Inventors:
- **ASANO Itaru**
  **Nagoya-shi**
  **Aichi 455-8502 (JP)**
- **OHNO Ayano**
  **Tokyo 103-8666 (JP)**
- **TAKEZAKI Hiroshi**
  **Nagoya-shi**
  **Aichi 455-8502 (JP)**

(74) Representative: **Webster, Jeremy Mark et al**
**Mewburn Ellis LLP**
**City Tower**
**40 Basinghall Street**
**London EC2V 5DE (GB)**

# (54) CONDUCTIVE FINE PARTICLES

(57) Disclosed are conductive microparticles, each of which is composed of a polymer microparticle and a conductive layer that is formed by coating the surface of the polymer microparticle with a metal. The conductive microparticles have an elastic modulus (E) at 5% displacement in a range of 1-100 MPa. Especially in cases where the conductive microparticles have a shape recovery ratio (SR) in a range of 0.1-13% under a load of 9.8 mN, a particle size distribution index of 1-3 and a particle size in a range of 0.1-100 μm, the conductive microparticles can exhibit excellent conduction reliability in applications such as conductive adhesives for flexible boards.

EP 2 947 663 A1

## Description

### Technical Field of the Invention

The present invention relates to conductive microparticles excellent in conduction reliability.

### Background Art of the Invention

Conductive microparticles are used in various fields such as adhesives in electronics fields, additives for pressure sensitive rubbers and additives for giving a conductivity to resin compositions.

For conductive microparticles in the early years, microparticles composed of a metal only such as silver particles or gold particles were used, and as a common problem when these particles were applied to various uses, because these particles were high in specific gravity relatively to a matrix resin, a problem such as sedimentation of metal particles occurred, and therefore, it was difficult to uniformly disperse the particles in the matrix resin.

In order to solve such a problem, disclosed is a method for utilizing conductive microparticles which are formed by coating resin particles as core materials with a metal or an inorganic compound (Patent documents 1 and 2).

On the other hand, in adhesives, pressure sensitive rubbers and resin compositions as uses of conductive microparticles, a higher durability is required under a severer usable environment such as a processing into a complicated shape, a resistance against flexure or elongation, or use at a high or low temperature, as compared with that in the conventional technology. In case of conductive microparticles in which resin particles are used as core materials, because the methods for producing the resin particles are limited, crosslinking acrylic particles or crosslinking polystyrene particles are used. However, in the conductive microparticles using these resin particles, in a use required with a more complicated shape, it is difficult to release a stress ascribed to change in shape and therefore a crack and the like may be caused, and at a defective portion such as the crack, electric conduction cannot be secured, and there is a problem that the conduction reliability is reduced.

### Prior art documents

Patent documents

Patent document 1: JP-A-2006-54066
Patent document 2: JP-A-9-185069

### Summary of the Invention

### Problems to be solved by the Invention

Accordingly, an object of the present invention is to provide conductive microparticles having a flexibility, high in conduction reliability, and suitable for applications such as flexible boards required with a flexibility in flexural use and the like.

### Means for solving the Problems

The inventors have reached the following present invention as the result of earnest investigation.

[1] Conductive microparticles, each of which is composed of a polymer microparticle and a conductive layer that is formed by coating a surface of the polymer microparticle with a metal, characterized in that an elastic modulus (E) at 5% displacement of the conductive microparticles is in a range of 1-100 MPa.
[2] The conductive microparticles according to [1], wherein a shape recovery ratio (SR) of the conductive microparticles under a load of 9.8 mN is in a range of 0.1-13%.
[3] The conductive microparticles according to [1] or [2], wherein a particle size distribution index of the conductive microparticles is in a range of 1.0-3.0.
[4] The conductive microparticles according to any one of [1] to [3], wherein a polymer of the polymer microparticle is a polyetherester copolymer or a polyamide elastomer.
[5] The conductive microparticles according to any one of [1] to [4], wherein a volume-based average particle size of the conductive microparticles is in a range of 0.1-100 μm.

[6] The conductive microparticles according to any one of [1] to [5], wherein a flexural elastic modulus of a polymer of the polymer microparticle is in a range of 10-1500 MPa.

Effect according to the Invention

In the conductive microparticles according to the present invention, an effect can be exhibited wherein, because of the high flexibility, even in flexural deformation in a flexible board and the like, crack and the like of the conductive microparticles does not occur, and a high conduction reliability can be obtained, and the conductive microparticles according to the present invention can be used suitably for antistatic molded articles, inks for electronic circuits, conductive adhesives, electromagnetic wave shielding molded articles, conductive paints, conductive spacers, etc. In particular, the conductive microparticles are very useful in a point capable of maintaining conduction, because the microparticles can deform without cracking for a processing into a complicated shape, a flexure or an elongation.

Embodiments for carrying out the Invention

Hereinafter, the present invention will be explained in detail together with embodiments.

Each of the conductive microparticles according to the present invention is composed of a polymer microparticle and a conductive layer that is formed by coating a surface of the polymer microparticle with a metal. The conductive microparticles according to the present invention are characterized in that the elastic modulus (E) at 5% displacement due to compression is in a range of 1-100 MPa.

Here, the elastic modulus (E) in the present invention will be explained.

As a relational equation for calculating an elastic modulus from a load applied to a spherical material and its displacement, it is known that the following equation (1) can be introduced from Hertz's theory of contact that is a theory for determining deformation of the spherical material.

[Equation 1]

$$\delta^3 = \frac{9P^2}{16E^2R} \quad (1)$$

In the above-described equation (1), represented are E: elastic modulus at the time of displacement of spherical material, δ: strain at the time of displacement of spherical material, P: load applied to spherical material, and R: diameter of spherical material.

Although the above-described equation (1) is an effective relational equation in an elastic deformation region, in case of a polymer, from its viscoelastic property, particularly in a large displacement region, it cannot be managed as elastic deformation, and it becomes difficult to apply this equation. Accordingly, with respect to deformation of conductive microparticles, it is important to determine it in a region capable of causing an elastic deformation, and in case of polymer microparticles, it is preferred to employ 5% as a standard of the deformation amount for the determination.

If the elastic modulus (E) of polymer microparticles is within the range defined in the present invention, when the microparticles are used as a filler of a matrix resin for use such as adhesives or pressure sensitive rubbers, the conduction reliability can be improved without causing a defect due to a crack and the like of the particles. In the present invention, although the upper limit of the elastic modulus (E) of the conductive microparticles when the surface of a conductive microparticle is displaced by 5% by applying a compression load to the conductive microparticle (elastic modulus (E) at 5% displacement of the conductive microparticles) is defined to be 100 MPa, from the viewpoint capable of more improving the conduction reliability, this upper limit of the elastic modulus (E) is preferably 80 MPa or less, more preferably 60 MPa or less, and particularly preferably 50 MPa or less. If the conductive microparticles are too flexible, because there is a possibility that the conductive layer cracks by an excessive deformation, although the lower limit of the elastic modulus (E) is defined to be 1 MPa, this lower limit is preferably 5 MPa or more, more preferably 10 MPa or more, further preferably 20 MPa or more, and particularly preferably 30 MPa or more.

The above-described elastic modulus (E) at 5% displacement due to compression is calculated using the following equation (2), in which a micro compression tester (supplied by Shimadzu Corporation, type: MCT-210) is used, conductive microparticles are placed on a bed for compression, a diameter of a conductive microparticle randomly selected from the placed microparticles is measured and the measured value is referred to as R, a load value at 5% displacement relative to the particle size (R) of the conductive microparticle, determined when loaded by a diamond

indenter with a diameter of 50 μm up to 9.8 mN at a compression speed of 0.29 mN/sec., is referred to as $P_{5\%}$, and a strain at 5% displacement is referred to as δ. Where, this determination is carried out with respect to randomly selected 10 conductive microparticles, and an average value thereof is defined as the elastic modulus (E) at 5% displacement due to compression in the present invention.

[Equation 2]

$$E = \frac{\sum_{i=1}^{n} \left( \frac{3}{4} \cdot P_{5\%} \cdot \delta^{-3/2} \cdot R^{-1/2} \right)}{n} \quad (2)$$

In the above-described equation (2), represented are E: elastic modulus at 5% displacement (MPa), n: measurement times (= 10), δ: strain at 5% displacement of each particle (mm), $P_{5\%}$: load value at 5% displacement of each particle (kgf), and R: particle size of each particle (mm).

In the conductive microparticles according to the present invention, if a shape recovery ratio of the conductive microparticles under a load of 9.8 mN is in a range of 0.1-13%, when applied to the use for adhesives or pressure sensitive rubbers, the conductive microparticles can deform flexibly without causing cracks even at the time of a more complicated deformation such as flexure or elongation of a matrix resin, and it is possible to improve the durability for securing conduction. Further, because the particles are filled at a condition of being deformed, they can be filled at a high concentration in the matrix resin, and it becomes possible to improve the conductivity. The upper limit of the shape recovery ratio under a load of 9.8 mN is preferably 11% or less, more preferably 9% or less, further preferably 7% or less, and most preferably 5% or less, because the conductive microparticles can deform more easily. If the deformation amount is too great, since there is a possibility that a conductive layer cracks although the particles can deform flexibly, the lower limit is preferably 0.5% or more, more preferably 1% or more, further preferably 2% or more, and most preferably 3% or more.

Where, the shape recovery ratio (SR) of the conductive microparticles under a load of 9.8 mN is calculated using the following equation (3), in which a micro compression tester (supplied by Shimadzu Corporation, type: MCT-210) is used, conductive microparticles are placed on a bed for compression, after a conductive microparticle randomly selected from the placed microparticles is measured, a deformation amount of the microparticle, determined when loaded by a diamond indenter with a diameter of 50 μm up to 9.8 mN at a compression speed of 0.29 mN/sec., is referred to as $L_1$ μm), thereafter, a displacement of the microparticle, determined when unloaded down to 1 mN at a speed of 0.29 mN/sec., is referred to as $L_2$ μm), and this determination is carried out with respect to randomly selected 10 conductive microparticles.

[Equation 3]

$$SR = \frac{\sum_{i=1}^{n} (L_2 / L_1)}{n} \times 100 \quad (3)$$

In the above-described equation (3), represented are SR: shape recovery ratio (%), n: measurement times (= 10), $L_1$: deformation amount of each microparticle when loaded up to 9.8 mN (μm), and $L_2$: displacement of each microparticle when unloaded in the compression.

The particle size of the conductive microparticles according to the present invention is usually in a range of 0.1-100 μm. Because it is difficult to give a sufficient flexibility when used as an additive for paints or adhesives, the lower limit is preferably 0.2 μm or more, more preferably 0.5 μm or more, further preferably 1 μm or more, particularly preferably 2 μm or more, extremely preferably 5 μm or more, and most preferably 7 μm or more. If the conductive microparticles are coarse, because sedimentation of particles occurs in the use for paints and the like and the handling ability deteriorates, the upper limit is 100 μm or less, preferably 50 μm or less, more preferably 30 μm or less, further preferably 25 μm or less, particularly preferably 20 μm or less, and most preferably 15 μm or less.

The particle size distribution index of the conductive microparticles according to the present invention is preferably in a range of 1.0-3.0. Since the smaller the particle size distribution index is, the more uniformed the distance between contacts is and the more improved the conduction reliability between boards is, it is preferably 3.0 or less, more preferably 2.0 or less, further preferably 1.8 or less, particularly preferably 1.5 or less, and most preferably 1.3 or less. Where, the particle size distribution index of the conductive microparticles in the present invention is calculated by the equation (6) described later as a ratio of a volume-based average particle size to a number-based average particle size of microparticles.

Where, the volume-based average particle size of the conductive microparticles in the present invention is calculated by the equation (5) described later after observing and measuring the diameters of 100 particles randomly selected in a photograph of a scanning electron microscope. The particle size distribution index is calculated by the equation (6) described later as a ratio of the volume-based average particle size to a number-based average particle size. The number-based average particle size is calculated by the equation (4) described later after observing and measuring the diameters of 100 particles randomly selected in a photograph of a scanning electron microscope. Where, in case where the particle is not a true circle, its long diameter is measured.

Although it is preferred that the shape of conductive microparticles is a true circle, because it is deformed to an oval-like shape by a load, it may be oval-like.

Each of the conductive microparticles according to the present invention is composed of a polymer microparticle and a conductive layer that is formed by coating the surface of the polymer microparticle with a metal. As the metal used for the conductive layer, although it is not particularly limited, metals such as nickel, gold, silver, copper, platinum, aluminum, palladium, cobalt, tin, indium, lead and iron are exemplified, and from the viewpoint of conductivity, metals such as gold, silver and copper are particularly preferred.

It is preferred that the thickness of the above-described conductive layer is in a range of 0.01-5 μm. If the conductive layer is thick, because the apparent specific gravity of the conductive microparticles increases and sedimentation thereof in a matrix resin occurs, more desirably, the thickness is preferably 3 μm or less, more preferably 1 μm or less, and most preferably 0.8 μm or less. If the conductive layer is too thin, because a sufficient conductivity cannot be secured, more desirably, the thickness is preferably 0.05 μm or more, more preferably 0.1 μm or more, further preferably 0.2 μm or more, and most preferably 0.4 μm or more.

The material of the polymer microparticle, which is a core material used for the conductive microparticles according to the present invention, is preferably a thermoplastic resin, in order to control the elastic modulus (E) at 5% displacement due to compression of the conductive microparticles in a range of 1-100 MPa.

As such a thermoplastic resin, a polyamide, a polyester, a polycarbonate, a polyphenylene ether, a polyamideimide, a polyetherimide, a polyether sulfone, a polyarylate, a polyamide elastomer, a polyester elastomer, etc. can be exemplified, and because the elastic modulus (E) at 5% displacement due to compression of the conductive microparticles can be controlled in the range of the present invention, aliphatic polyamides such as Nylon 12, Nylon 11 and Nylon 1010, a polyamide elastomer, and a polyester elastomer such as a polyetherester block copolymer are preferred. Further, if the polymer, which is a raw material of the polymer microparticles, is a polymer having a flexural elastic modulus in a range of 10-1500 MPa and the thermal deformation temperature thereof is 160°C or higher, because it is possible to give conduction reliability under a high temperature to adhesives and the like using the conductive microparticles, a polyamide elastomer and a polyetherester block copolymer are particularly preferred. If the elastic modulus of the conductive microparticles is too high, because cracks of the polymer microparticles are likely to occur, the flexural elastic modulus of the polymer is preferably 1300 MPa or less, further preferably 1100 MPa or less, and more preferably 900 MPa or less. If the conductive microparticles become very flexible, because there is a possibility that a crack and the like of the conductive layer due to deformation occurs, the flexural elastic modulus of the polymer is desirably 10 MPa or more, preferably 50 MPa or more, more preferably 100 MPa or more, further preferably 300 MPa or more, and particularly preferably 500 MPa or more.

From these points, as the thermoplastic resin to be used, a polyamide elastomer and a polyester elastomer such as a polyetherester block copolymer are extremely preferred. Further, because the durability at a high temperature is improved and the conduction reliability is improved, the thermal deformation temperature is preferably 170 °C or higher, more preferably 180 °C or higher, particularly preferably 190°C or higher, and most preferably 200°C or higher, and from this point, a polyetherester block copolymer is most preferred as the thermoplastic resin to be used. Although the upper limit is not particularly restricted, because decomposition of the thermoplastic resin is likely to occur, the upper limit is preferably 300°C or lower, and more preferably 280°C or lower.

Where, the flexural elastic modulus referred to in the present invention means a value determined based on ASTM-D790-98. In this determination, a specimen for flexure test with a size of 127 x 12.7 x 6.4 mm, obtained by molding pellets, prepared by drying polymer pellets with hot air at 90 °C for 3 hours or more, at molding conditions of a cylinder temperature of 240°C and a mold temperature of 50°C using an injection molding machine (supplied by Nissei Plastic Industrial Co., Ltd., NEX-1000), is used as a sample.

Further, the thermal deformation temperature referred to in the present invention indicates a glass transition temperature or a melting point, and indicates a melting point for a polymer having a glass transition temperature and a

melting point together. The glass transition temperature means a glass transition temperature determined at conditions under a nitrogen gas atmosphere and at a temperature elevation speed of 10°C/min. from 30°C, using a differential scanning calorimeter (for example, Robot DSC RDC 220, supplied by Seiko Instruments Inc.). The melting point means a melting point determined at a temperature elevation speed of 10 °C/min. using a differential scanning calorimeter (for example, Robot DSC RDC 220, supplied by Seiko Instruments Inc.).

Further, the polyetherester block copolymer in the present invention is a block copolymer containing a polyester unit and a polyether unit. The polyester unit may contain an ester bond in the principal chain or side chain, and although not particularly limited, it can be obtained by condensation polymerization from an acid component and a glycol component.

As the acid component forming the polyester unit, can be used terephthalic acid, isophthalic acid, phthalic acid, 2,5-dimethyl terephthalic acid, 1,4-naphthalene dicarboxylic acid, biphenyl dicarboxylic acid, 2,6-naphthalene dicarboxylic acid, 1,2-bisphenoxy ethane-p, p'-dicarboxylic acid, phenylindane dicarboxylic acid, succinic acid, adipic acid, sebacic acid, azelaic acid, dodecanedionic acid, dimer acid, 1,3-cyclopentane dicarboxylic acid, 1,2-cyclohexane dicarboxylic acid, 1,4-cyclohexane dicarboxylic acid, etc., and ester forming derivatives thereof, and further, as an acid component containing a sulfonic group and a base thereof, for example, can be used metal salts such as 5-sulfoterephthalic acid, sulfoisophthalic acid, 4-sulfoisophthalic acid, 4-sulfonaphthalene-2,7-dicarboxylic acid, sulfo-p-xylylene glycol, 2-sulfo-1,4-bis(hydroxyethoxy) benzene, and these are copolymerized using one kind or two or more kinds.

As the glycol component forming the polyester unit, can be used ethylene glycol, diethylene glycol, polyethylene glycol, propylene glycol, polypropylene glycol, 1,3-propane diol, 1,3-butane diol, 1,4-butane diol, 1,5-pentane diol, 1,6-hexane diol, 1,7-heptane diol, 1,8-octane diol, 1,9-nonane diol, 1,10-decane diol, 2,4-dimethyl-2-ethylhexane-1,3-diol, neopentyl glycol, 2-ethyl-2-butyl-1,3-propane diol, 2-ethyl-2-isobutyl-1,3-propane diol, 3-methyl-1,5-pentane diol, 2,2,4-trimethyl-1,6-hexane diol, 1,2-cyclohexane dimethanol, 1,3-cyclohexane dimethanol, 1,4-cyclohexane dimethanol, 2,2,4,4-tetramethyl-1,3-cyclobutane diol, 4,4'-thiodiphenol, bisphenol A, 4,4'-methylene diphenol, 4,4'-(2-norbornylidene) diphenol, cyclopentane-1,2-diol, cyclohexane-1,2-diol, cyclohexane-1,4-diol, etc., and these are copolymerized using one kind or two or more kinds.

As the polyester unit in the present invention, a polyester unit prepared by an aromatic dicarboxylic acid and a glycol by condensation polymerization is preferred from the viewpoint of flexural elastic modulus and thermal deformation temperature, and polyethylene terephthalate, polybutylene terephthalate, etc. are most preferred.

The polyether unit in the present invention is represented by the following chemical formula (chemical formula 1).

[Chemical formula 1]

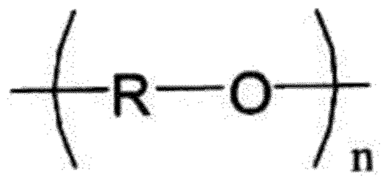

In the above-described chemical formula 1, R represents a divalent aliphatic group, and concretely, a straight chain saturated hydrocarbon group, a divergent saturated hydrocarbon group, a straight chain unsaturated hydrocarbon group and a divergent unsaturated hydrocarbon group can be exemplified. "n" represents a number of repeated units, and indicates a positive number. As the above-described straight chain saturated hydrocarbon group, divergent saturated hydrocarbon group, straight chain unsaturated hydrocarbon group and divergent unsaturated hydrocarbon group, the carbon number thereof is preferably in a range of 1-20, in particular, preferably in a range of 1-10 from the viewpoint capable of exhibiting excellent thermal deformation temperature.

As concrete examples of the polyether unit, can be exemplified polyethylene glycol, polypropylene glycol, polytrimethylene glycol, polytetramethylene glycol, polyhexamethylene glycol, copolymer of ethylene oxide and propylene oxide, ethylene oxide adduct of polypropylene glycol, copolymer of ethylene oxide and tetrahydrofuran, etc. From the viewpoint of improving the thermal deformation temperature, it is particularly preferred that the carbon number of R is in a range of 1-10, such as polyethylene glycol, polypropylene glycol, polytrimethylene glycol, polytetramethylene glycol, etc.

The content of the polyether unit is 90 mass % or less in a polyetherester block copolymer, and from the viewpoint of improving the flexural elastic modulus of a resin, it is preferably 80 mass % or less, and more preferably 70 mass % or less. The lower limit is 2 mass % or more, preferably 5 mass % or more, more preferably 10 mass % or more, and most preferably 20 mass % or more.

Although the weight-based average molecular weight of the polyetherester block copolymer microparticles in the present invention is not particularly restricted, it is usually in a range of 1,000-100,000, preferably in a range of

2,000-60,000, and more preferably in a range of 3,000-40,000. Where, the weight-based average molecular weight means a weight-based average molecular weight calculated by determining it by gel permeation chromatography (GPC) using hexafluoroisopropanol as a solvent and converting the determined value with standard polystyrene.

The particle size of the polymer microparticles in the present invention, when coated with conductive layer, is usually in a range of 0.1-100 μm, although it is not particularly restricted as long as the volume-based average particle size of the conductive microparticles becomes in a range of 0.1-100 μm. Because a sufficient conduction reliability cannot be secured when the conductive microparticles are used as additives of paints or adhesives, the lower limit of the volume-based average particle size of the polymer microparticles is preferably 0.2 μm or more, more preferably 0.5 μm or more, further preferably more than 1 μm, particularly preferably 2 μm or more, extremely preferably 5 μm or more, and most preferably 7 μm or more. If the conductive microparticles are coarse, because sedimentation of particle in a use such as paints and the handling ability deteriorates, the upper limit of the volume-based average particle size of the polymer microparticles is desirably less than 100 μm, preferably 50 μm or less, more preferably 30 μm or less, further preferably 25 μm or less, particularly preferably 20 μm or less, and most preferably 15 μm or less.

It is preferred that the particle size distribution index of the polymer microparticles in the present invention is in a range of 1.0-3.0, because it becomes a particle size distribution index of the conductive microparticles. Since the smaller the particle size distribution index of the conductive microparticles is, the more uniformed the distance between contacts is and the conduction reliability between boards is more improved, it is preferably 3.0 or less, more preferably 2.0 or less, further preferably 1.8 or less, particularly preferably 1.5 or less, and most preferably 1.3 or less. This particle size distribution index of the polymer microparticles calculated by the equations (4), (5) and (6) described later, as a ratio of a volume-based average particle size to a number-base average particle size, based on the calculation method of the particle size distribution index of the conductive microparticles described later. Where, the average particle size is determined as its long diameter in case where the particle is not a true circle.

As a method for producing the conductive microparticles according to the present invention, for example, an electroless plating, a method for coating metal powder to polymer microparticles together with a binder, an ion sputtering, a vacuum deposition, etc. can be exemplified, and an electroless plating is preferably employed because a defect of a conductive layer does not occur and a uniform conductive layer is liable to be formed.

In the electroless plating, polymer microparticles or an aqueous slurry of polymer microparticles is added to an electroless plating liquid containing a salt of a desired conductive metal, a reductant, a complexing agent, various additives and the like to perform the electroless plating treatment.

As the conductive metal salt, exemplified are chlorides, sulfates, acetates, nitrates, carbonates, etc. of the metals exemplified before as metals for the conductive layer. For example, in case where a nickel layer is required to be formed as the conductive layer, nickel salts such as nickel chloride, nickel sulfate or nickel acetate can be exemplified. From the viewpoint of easily forming a conductive layer, as the salt, gold salt, silver salt and copper salt are preferred, and in particular, silver salt is preferred. As the kind of silver salt, for example, although a silver oxide, a silver chloride, a silver sulfate, a silver carbonate, a silver nitrate, a silver acetate, etc. can be used, a silver nitrate is most preferable from the viewpoints of solubility and economy.

As the reductant, sodium hypophosphite, borane dimethylamine complex, sodium borohydride, potassium borohydride, hydrazine, glyoxal, formaldehyde, ascorbic acid, glucose, hydroquinone, formic acid, etc. are used, and because defects of the conductive layer are hard to be caused and reduction to silver can be performed in a short period of time, glucose, glyoxal, formaldehyde and ascorbic acid are preferred.

A preferred pH of the electroless plating liquid in the electroless plating is in a range of 4-14. Here, in case where a conductive layer is formed by electroless plating in particular on polyamide elastomer or polyetherester copolymer among the polymer microparticles in the present invention, the state of the conductive layers of the obtained conductive microparticles changes depending upon pH. In particular, in case of strong alkali condition, because defects are caused on the surfaces of the polymer microparticles as the time passes and uniform conductive layers are hard to be formed, the pH of the electroless plating liquid is preferably in a range of 4-12, more preferably in a range of 4-10, and particularly preferably in a range of 4-8. By performing the electroless plating reaction under such a range of pH, it is possible to produce conductive microparticles which do not cause defects of conductive layers.

It is possible to employ a known method as the method for producing the polymer microparticles. Concretely, exemplified are a drying-in-liquid method for dissolving a polymer in an organic solvent, forming an O/W emulsion by being added into water, and thereafter, removing the solvent by pressure-reduced drying to produce microparticles, and a method, described in WO 2012/043509, for dissolving a polymer (A) and a polymer (B) different from the polymer (A) in an organic solvent to form an emulsion, and thereafter, bringing water, which is a poor solvent of the polymer (A), into contact with the emulsion to produce microparticles. In particular, because it is possible to produce polymer microparticles having a particle size distribution index of 1.0-3.0, a method, described in WO 2012/043509, is preferred for dissolving a polymer (A) and a polymer (B) different from the polymer (A) in an organic solvent, and after forming an emulsion at a temperature of 100°C or higher, bringing water, which is a poor solvent of the polymer (A), into contact with the emulsion to produce microparticles.

Further, since it is possible to produce flexible polymer microparticles usable as a raw material of the conductive microparticles having a conduction reliability according to the present invention, the above-described production method is preferably a method for using a polymer (A) having a flexural elastic modulus in a range of 100-1500 MPa, using any one of polyvinyl alcohol, polyethylene glycol and hydroxyl propyl cellulose as the polymer (B) different from the polymer (A), using an aprotic polar solvent as the organic solvent, and after forming the emulsion, bringing water, which is a poor solvent of the polymer (A), into contact with the emulsion to produce microparticles.

If the flexibility of the polymer microparticles increases, because the conduction reliability of the conductive microparticles can be improved, the flexural elastic modulus of polymer (A) is preferably 1300 MPa or less, more preferably 1100 MPa or less, and further preferably 900 MPa or less. If the polymer microparticles are too flexible, because cracks of the conductive layer due to deformation of the conductive microparticles may be caused, the flexural elastic modulus of polymer (A) is desirably 10 MPa or more, preferably 50 MPa or more, more preferably 100 MPa or more, further preferably 300 MPa or more, and particularly preferably 500 MPa or more.

As the polymer (A) having such a range of flexural elastic modulus, a polyamide elastomer or a polyetherester block copolymer is preferred, and from the viewpoint capable of providing also thermal resistance to the conductive microparticles, a polyetherester block copolymer is particularly preferred.

Further, because it is possible to produce polymer microparticles narrow in particle size distribution or polymer microparticles small in particle size, as the polymer (B), polyvinyl alcohol or polyethylene glycol is preferred, and polyvinyl alcohol is particularly preferred.

As the organic solvent, from the viewpoint capable of using industrially, N-methyl-2-pyrrolidone, dimethyl sulfoxide, N,N-dimethyl formamide, N,N-dimethyl acetamide, propylene carbonate, etc. are preferred, and N-methyl-2-pyrrolidone and dimethyl sulfoxide are particularly preferred, and N-methyl-2-pyrrolidone is most preferred. These solvents may be used either as a form of a plurality of kinds or solely.

Since the conductive microparticles have a feature, because of their high flexibility, that the conduction reliability is high without causing cracks and the like of the conductive microparticles even if deformed by flexure in a flexible board and the like, they are suitable for antistatic molded articles, inks for electronic circuits, conductive adhesives, electromagnetic wave shielding molded articles, conductive paints, conductive spacers, etc. Further, because the particles can deform without cracking for a processing into a complicated shape, a flexure or an elongation, they are very useful in a point capable of maintaining conduction.

## Examples

Next, the present invention will be explained in more detail based on Examples. However, the present invention is not limited to these Examples only. In the Examples, used determinations are as follows.

(1) Determination of weight-based average molecular weight of polymer and polymer microparticles:

The weight-based average molecular weight was calculated by using gel permeation chromatography and comparing with a calibration curve due to polystyrene.
Equipment: LC-10A series, supplied by Shimadzu Corporation

Column: HFIP-806M x 2, supplied by Showa Denko K.K.
Moving phase: hexafluoroisopropanol

Flow rate: 0.5 ml/min.
Detection: differential refractometer
Column temperature: 25°C

(2) Calculation method of number-based average particle size, volume-based average particle size and particle size distribution index:

The volume-based average particle size of microparticles is determined by observing 100 particles randomly selected and measuring the diameters thereof in a photograph taken by a scanning electron microscope, and calculating by the following equation (5). The particle size distribution index is calculated as a ratio of a volume-based average particle size to a number-based average particle size, based on the following equation (6). The number-based average particle size is determined by observing 100 particles randomly selected and measuring the diameters thereof in a photograph taken by a scanning electron microscope, and calculating by the following equation (4). Where, if the shape of the particle is not a perfect circle, a long diameter of the particle is measured.
[Equation 4]

$$Dn = \sum_{i=1}^{n} Ri \Big/ n \quad (4)$$

[Equation 5]

$$Dv = \sum_{i=1}^{n} Ri^{4} \Big/ \sum_{i=1}^{n} Ri^{3} \quad (5)$$

[Equation 6]

$$PDI = Dv / Dn \quad (6)$$

Where, in the above-described respective equations, Ri represents a particle size of each particle, n represents the number of measurements (100), Dn represents the number-based average particle size, Dv represents the volume-based average particle size, and PDI represents the particle size distribution index.

(3) Determination of thermal deformation temperature:

Using Robot DSC RDC 220 supplied by Seiko Instruments Inc., and heating under a nitrogen gas atmosphere and at a temperature elevation speed of 10°C/min., a glass transition temperature and a melting point were determined.

(4) Determination of compression elastic modulus (E) at 5% displacement of conductive microparticles:

The compression elastic modulus (E) at 5% displacement of conductive microparticles was determined by the following method using a micro compression tester (supplied by Shimadzu Corporation, type: MCT-210).

Conductive microparticles were placed on a bed for compression of the micro compression tester, a particle size (R) of a conductive microparticle randomly selected from the placed microparticles was measured, and the elastic modulus (E) was calculated by the following equation (2), from a load value at 5% displacement ($P_{5\%}$) relative to the particle size (R) of the conductive microparticle, determined when loaded by a diamond indenter with a diameter of 50 μm up to 9.8 mN at a compression speed of 0.29 mN/sec., and a strain (δ) at 5% displacement. Where, this determination was carried out with respect to randomly selected 10 conductive microparticles, the compression elastic moduli at 5% displacement of the respective microparticles were measured, and an arithmetic average value thereof was defined as the compression elastic modulus (E) at 5% displacement in the present invention.
[Equation 7]

$$E = \frac{\sum_{i=1}^{n} \left( \frac{3}{4} \cdot P_{5\%} \cdot \delta^{-3/2} \cdot R^{-1/2} \right)}{n} \quad (2)$$

Where, represented are E: elastic modulus at 5% displacement (MPa), n: measurement times (= 10), δ: strain

at 5% displacement of each particle (mm), $P_{5\%}$: load value at 5% displacement of each particle (kgf), and R: particle size of each particle (mm).

(5) Shape recovery ratio after loading (SR):

The shape recovery ratio (SR) of conductive microparticles under a load of 9.8 mN is calculated using the following equation (3), in which a micro compression tester (supplied by Shimadzu Corporation, type: MCT-210) is used, conductive microparticles are placed on a bed for compression, after a conductive microparticle randomly selected from the placed microparticles is measured, a deformation amount of the microparticle, determined when loaded by a diamond indenter with a diameter of 50 μm up to 9.8 mN at a compression speed of 0.29 mN/sec., is referred to as $L_1$ (μm), thereafter, a displacement of the microparticle, determined when unloaded down to 1 mN at a speed of 0.29 mN/sec., is referred to as $L_2$ μm), and this determination is carried out with respect to randomly selected 10 conductive microparticles.
[Equation 8]

$$SR = \frac{\sum_{i=1}^{n} (L_2/L_1)}{n} \times 100 \qquad (3)$$

Where, represented are SR: shape recovery ratio (%), n: measurement times (= 10), $L_1$: deformation amount of each microparticle when loaded up to 9.8 mN (μm), and $L_2$: displacement of each microparticle when unloaded in the compression.

(6) Flex resistance test and Evaluation of conduction reliability:

A conductive adhesive was applied onto an ITO film (10 x 70 x 0.2 mm), thereon a copper foil (10 x 70 x 0.2 mm) was placed, the conductive adhesive was adjusted so that the thickness became 1 mm, and it was cured under conditions of 180 °C and 30 min. The obtained film was flexed repeatedly (a flexure at an angle of 180 degrees was counted as one time), at the time of each of 10th, 50th and 100th flexures, electrodes of a digital multi-meter (supplied by ADC Corporation) were attached to the respective ITO side and copper foil side so as to nip the flexure portion, the electric resistance was measured, and the conduction was evaluated. From the result of the conduction relative to the times of flexure, the synthetic evaluation was determined as follows.

A: Conduction can be secured even at 100th flexure.
B: Conduction can be secured even at 50th flexure, but conduction cannot be secured at 100th flexure.
C: Conduction can be secured even at 10th flexure, but conduction cannot be secured at 50th flexure.
D: Conduction has been already lost at 10th flexure.

Where, ranks A and B are determined that there is conduction reliability, and ranks C and D are determined that there is not conduction reliability.

[Production Example 1]: Polyetherester block copolymer

Terephthalic acid of 42.7 parts, 1,4-butane diol of 37.3 parts and polytetramethylene glycol having a weight-based average molecular weight of about 3,000 of 20.0 parts were charged into a reaction vessel having a helical ribbon type stirring blade together with titanium tetrabutoxide of 0.01 part and mono-n-butyl-monohydroxy tin oxide of 0.005 part, and they were served to esterification by heating them at 190 to 225°C for 3 hours while distilling reaction water outside the system. Tetra-n-butyl titanate of 0.06 part was additionally added to the reaction mixture, after "IRGANOX" 1098 (hindered phenol-based antioxidant, supplied by Ciba Japan K.K.) of 0.02 part was added, the temperature of the system was elevated up to 245°C, then the pressure in the system was reduced by 30 Pa for 50 minutes, and under that condition, polymerization was taken place for 2 hours and 50 minutes to obtain polyetherester block copolymer. The melting point was 224°C, the weight-based average molecular weight was 27,000, and the flexural elastic modulus was 1,100 MPa.

[Production Example 2]: production of polymer microparticles

33.25g of polyetherester block copolymer prepared in Production Example 1 (weight-based average molecular weight: 27,000), 299.25g of N-methyl-2-pyrrolidone and 17.5g of polyvinyl alcohol (supplied by Wako Pure Chemical Industries, Ltd., PVA-1500, weight-based average molecular weight: 29,000, reduced in content of sodium acetate down to 0.05 mass% by methanol washing) were added into a 1,000 ml pressure resistant glass autoclave (supplied by Taiatsu Techno Corporation, Hyper Glaster, TEM-V1000N), after replaced with nitrogen, heated up to 180°C, and stirred for 4 hours until the polymers were dissolved. Thereafter, 350g of ion exchange water was dropped as a poor solvent at a speed of 2.92 g/min. through a feeding pump. After the whole amount of water was completely poured, the temperature was lowered while being stirred, the obtained suspension was filtered, re-slurry washing was performed by adding 700g of ion exchange water, and the filtrated substances were vacuum dried at 80°C for 10 hours to obtain 28.3g of white solid materials. When the obtained powder were observed by a scanning electron microscope, they were microparticles composed of polyetherester block copolymer having a true sphere-like shape, a volume-based average particle size of 14.7 μm, and a particle size distribution index of 1.23.

[Production Example 3]: production of polymer microparticles

It was carried out similarly to that in Production Example 2 other than the conditions changing to 35.00g of polyetherester block copolymer prepared in Production Example 1 (weight-based average molecular weight: 27,000), 300.00g of N-methyl-2-pyrrolidone and 15.0g of polyvinyl alcohol (supplied by Wako Pure Chemical Industries, Ltd., PVA-1500, weight-based average molecular weight: 29,000, reduced in content of sodium acetate down to 0.05 mass% by methanol washing). When the obtained powder were observed by a scanning electron microscope, they were microparticles composed of polyetherester block copolymer having a true sphere-like shape, a volume-based average particle size of 18.5 μm, and a particle size distribution index of 1.27.

[Example 1]: production of conductive microparticles

40g of the polymer microparticles prepared in Production Example 2 were added to 160g of water adjusted to 5 in pH, after substitution reaction was carried out while slowly adding 88 mL of silver nitrate ammonia solution (prepared by adding 7.7g of silver nitrate to water and adding aqueous ammonia thereto so as to control the amount to 88 mL) taking a time of 30 min., 5.0g of glucose was added and reduction was performed for 30 min. to prepare conductive microparticles with silver plate. The prepared conductive microparticles were separated and washed by ion exchange water, and vacuum dried at 80°C, to obtain conductive microparticles. The volume-based average particle size of the conductive microparticles was 10.5 μm, the particle size distribution index was 1.77, the compression elastic modulus (E) at 5% displacement of the conductive microparticles was 33 MPa, and the shape recovery ratio after loading (SR) was 1.2%.

[Example 2]: production of conductive microparticles

Silver plating was carried out similarly to that in Example 1 other than the condition using the polyetherester block copolymer microparticles prepared in Production Example 3. The volume-based average particle size of the conductive microparticles was 19.5 μm, the particle size distribution index was 1.31, the compression elastic modulus (E) at 5% displacement of the conductive microparticles was 33 MPa, and the shape recovery ratio after loading (SR) was 31%.

[Comparative Example 1]

The volume-based average particle size of "BRIGHT" 20GNR-EH supplied by Nippon Chemical Industrial Co., Ltd. was 4.6 μm, the particle size distribution index was 1.01, and the compression elastic modulus (E) at 5% displacement was 189 MPa.

[Comparative Example 2]

The polyetherester block copolymer prepared in Production Example 1 was served to freeze-fracture treatment. Thereafter, silver plating was carried out in accordance with the manner of Production Example 3. The volume-based average particle size of the conductive microparticles was 60 μm, the particle size distribution index was 5.2, and the compression elastic modulus (E) at 5% displacement of the conductive microparticles was 40 MPa.

[Table 1]

| | Conductive microparticles | | | | Properties of polymer | | |
|---|---|---|---|---|---|---|---|
| | E (MPa) | SR (%) | Dv(μm) | Particle size distribution index | Polymer | flexural elastic modulus (MPa) | thermal deformation temperature (°C) |
| **Example 1** | **33** | **1.2** | **10.5** | **1.77** | **polyetherester copolymer** | **1100** | **224** |
| **Example 2** | **33** | **31** | **19.5** | **1.31** | **polyetherester copolymer** | **1100** | **224** |
| **Comparative Example 1** | **189** | | **4.6** | **1.01** | **crosslinking acrylic** | **3000** | **-** |
| **Comparative Example 2** | **40** | | **60** | **5.2** | **polyetherester copolymer** | **1100** | **224** |

[Production Example 4]: method for preparing conductive adhesive

The mixture of 100g of bisphenol type epoxy resin ("JER 1004", supplied by Mitsubishi Chemical Corporation), 30g of curing agent; 4,4'-diaminnodiphenyl sulfone and 10g of conductive microparticles prepared in Example 1 was stirred at 2,000 rpm/min. for 3 minutes using a planetary centrifugal mixer "Awatori Rentarou ARE-310" (supplied by Thinky Corporation), to prepare a conductive adhesive.

[Example 3]

Using the conductive adhesive prepared in Production Example 4, when the flex resistance test and the evaluation of conduction reliability were performed, the conduction was secured even at 100th flexure, and it was determined to be Rank A exhibiting a high conduction reliability.

[Example 4]

Using the conductive microparticles prepared in Example 2, a conductive adhesive was prepared in accordance with the manner of Production Example 4, when the flex resistance test and the evaluation of conduction reliability were performed, although the conduction was secured even at 50th flexure, cracks occurred in the film at 60th flexure, and the conduction was lost at 100th flexure. Therefore, it was determined to be Rank B exhibiting a sufficient conduction reliability.

[Comparative Example 3]

Using the conductive microparticles prepared in Comparative Example 1, a conductive adhesive was prepared in accordance with the manner of Production Example 4, when the flex resistance test and the evaluation of conduction reliability were performed, cracks occurred in the film at 3rd flexure, the conduction was lost at 10th flexure, and it was determined to be Rank D exhibiting a low conduction reliability.

[Comparative Example 4]

Although preparation of a conductive adhesive was tried in accordance with the manner of Production Example 4 using the conductive microparticles prepared in Comparative Example 2, the conductive microparticles agglomerated, the conductive microparticles could not be dispersed in an epoxy resin, and coating could not be performed.

Industrial Applicability

The conductive microparticles according to the present invention have a feature that, because of the high flexibility, even in flexural deformation in a flexible board and the like, crack and the like of the conductive microparticles

does not occur, and a high conduction reliability is high, they are suitably applied to antistatic molded articles, inks for electronic circuits, conductive adhesives, electromagnetic wave shielding molded articles, conductive paints, conductive spacers, etc. Moreover, the conductive microparticles are very useful in a point capable of maintaining conduction, because the microparticles can deform without cracking for a processing into a complicated shape, a flexure or an elongation.

## Claims

1. Conductive microparticles, each of which is composed of a polymer microparticle and a conductive layer that is formed by coating a surface of the polymer microparticle with a metal, **characterized in that** an elastic modulus (E) at 5% displacement of said conductive microparticles is in a range of 1-100 MPa.

2. The conductive microparticles according to claim 1, wherein a shape recovery ratio (SR) of said conductive microparticles under a load of 9.8 mN is in a range of 0.1-13%.

3. The conductive microparticles according to claim 1 or 2, wherein a particle size distribution index of said conductive microparticles is in a range of 1.0-3.0.

4. The conductive microparticles according to any one of claims 1 to 3, wherein a polymer of said polymer microparticle is a polyetherester copolymer or a polyamide elastomer.

5. The conductive microparticles according to any one of claims 1 to 4, wherein a volume-based average particle size of said conductive microparticles is in a range of 0.1-100 μm.

6. The conductive microparticles according to any one of claims 1 to 5, wherein a flexural elastic modulus of a polymer of said polymer microparticle is in a range of 10-1500 MPa.

**INTERNATIONAL SEARCH REPORT**

International application No.
PCT/JP2014/050456

A. CLASSIFICATION OF SUBJECT MATTER
*H01B5/00*(2006.01)i

According to International Patent Classification (IPC) or to both national classification and IPC

B. FIELDS SEARCHED

Minimum documentation searched (classification system followed by classification symbols)
H01B5/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-164874 A (Osugi Kabushiki Kaisha), 10 June 2004 (10.06.2004), claims; paragraphs [0027] to [0047] (Family: none) | 1-6 |
| Y | JP 2008-251452 A (Daicel Chemical Industries, Ltd.), 16 October 2008 (16.10.2008), claims; paragraphs [0027] to [0081]; examples (Family: none) | 1-6 |
| Y | JP 2006-12709 A (Sanyo Chemical Industries, Ltd.), 12 January 2006 (12.01.2006), claims; examples (Family: none) | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>10 February, 2014 (10.02.14) | Date of mailing of the international search report<br>25 February, 2014 (25.02.14) |
| Name and mailing address of the ISA/<br>Japanese Patent Office<br><br>Facsimile No. | Authorized officer<br><br><br>Telephone No. |

Form PCT/ISA/210 (second sheet) (July 2009)

**INTERNATIONAL SEARCH REPORT**

International application No.
PCT/JP2014/050456

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2010/013668 A1 (Sekisui Chemical Co., Ltd.), 04 February 2010 (04.02.2010), paragraphs [0006] to [0010], [0088] (Family: none) | 1-6 |
| Y | JP 2003-45230 A (Hayakawa Rubber Co., Ltd.), 14 February 2003 (14.02.2003), claim 1 (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006054066 A
- JP 9185069 A
- WO 2012043509 A